# EUROPEAN PATENT APPLICATION

(11) **EP 2 756 913 A1**
(43) Date of publication of application: **23.07.2014**
(21) Application number: 12831088.5
(22) Date of filing: 26.07.2012
(51) Int. Cl.: B23K 35/14, B23K 35/22, B23K 35/26, C22C 9/00, C22C 13/00, C22C 13/02, H05K 3/34

(54) **ELECTROCONDUCTIVE MATERIAL, AND CONNECTION METHOD AND CONNECTION STRUCTURE USING SAME**

(30) Priority: 16.09.2011 JP 2011202938
(71) Applicant: Murata Manufacturing Co., Ltd., Nagaokakyo-shi, Kyoto 617-8555 (JP)
(72) Inventor: NAKANO, Kosuke, Nagaokakyo-shi Kyoto 617-8555 (JP); TAKAOKA, Hidekiyo, Nagaokakyo-shi Kyoto 617-8555 (JP)
(74) Representative: Thoma, Michael
(86) International application number: PCT/JP2012/068976
(87) International publication number: WO 2013/038817

(57) **Abstract**

Provided is an electroconductive material which has excellent strength in high temperatures, has good diffusion of a first metal and a second metal in a soldering step when the material is used, for example, as a solder paste, produces an intermetallic compound having a high melting point at a low temperature and in a short time, and wherein after soldering, almost none of the first metal remains.

Also provided are a connection method and connection structure using the material and having high connection reliability.

The electroconductive material includes a metal component containing a first metal and a second metal having a higher melting point than the first metal, and has a configuration in which the first metal is Sn or an alloy containing Sn, and the second metal is a Cu-Cr alloy which forms, with the first metal, an intermetallic compound exhibiting a melting point of 310°C or higher.

The first metal can be Sn alone or an alloy containing Sn and at least one of Cu, Ni, Ag, Au, Sb, Zn, Bi, In, Ge, Al, Co, Mn, Fe, Cr, Mg, Pd, Si, Sr, Te, and P.

## Description

### TECHNICAL FIELD

The present invention relates to an electroconductive material, and a connection method and a connection structure using the electroconductive material, and more particularly to an electroconductive material to be used for, for example, mounting of electronic parts or via connection, and a connection method and a connection structure using the electroconductive material.

### BACKGROUND ART

As the electroconductive material used in mounting the electronic part, a solder is widely used.

By the way, in the Sn-Pb solder previously widely used, a bonding method with temperature hierarchy is widely applied, in which soldering is performed at a temperature of 330 to 350°C by using Pb-rich Pb-5Sn (melting point: 314 to 310°C) or Pb-10Sn (melting point: 302 to 275°C) as a high temperature solder, for example, and then soldering is performed at a temperature of a melting point of the above high temperature solder or less by using Sn-37Pb eutectic (melting point: 183°C) of a low temperature solder, for example, and thereby, a connection by soldering is performed without melting the high temperature solder used in previous soldering.

Such a bonding method with temperature hierarchy is applied to a semiconductor device of a type in which a chip is die bonded or a semiconductor device which is subjected to a flip-chip bonding, and it is an important technique used for the case where a connection by soldering is performed in a semiconductor device, and then the semiconductor device itself is connected to a substrate by soldering.

As an electroconductive material used for this use, for example, a solder paste including a mixture of (a) second metals Cu, Al, Au, Ag and the like, or a second metal (or an alloy) ball composed of a high melting point alloy containing the second metal, and (b) a first metal ball composed of Sn or In is proposed (Patent Document 1).

Further, in Patent Document 1, a connection method using a solder paste, and a method for manufacturing an electronic equipment are disclosed.

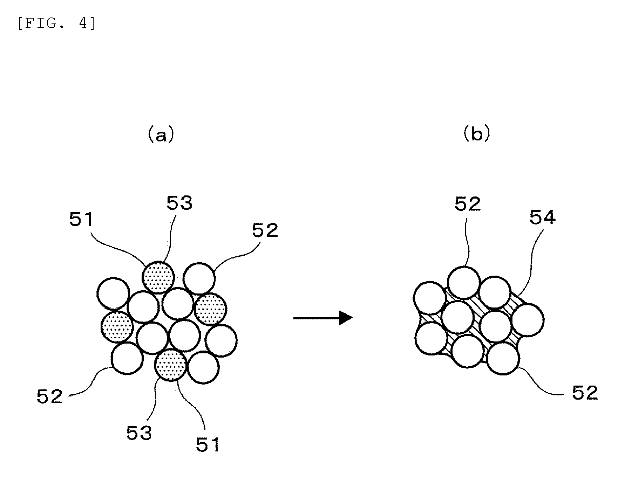

When soldering is performed by using a solder paste described in Patent Document 1, as schematically shown in FIG. 4(a), the solder paste including low melting point metal (e.g., Sn) balls 51, high melting point metal (e.g., Cu) balls 52 and a flux 53 is heated to react, and after soldering, as shown in FIG. 4(b), a plurality of high melting point metal balls 52 are connected to one another across an intermetallic compound 54 formed between a low melting point metal originating from the low melting point metal ball and a high melting point metal originating from the high melting point metal ball, and by this connecting body, connecting objects are connected (soldered) to each other.

However, in the case of the solder paste described in Patent Document 1, the intermetallic compound between the high melting point metal (e.g., Cu) and the low melting point metal (e.g., Sn) is produced by heating the solder paste in a soldering step, and in the combination of Cu (high melting point metal) and Sn (low melting point metal), diffusion rates of these metals are slow, and therefore a large amount of Sn being a low melting point metal remains. In the case of a solder paste in which Sn remains, joint strength under elevated temperature is significantly deteriorated, and there may be cases where a product cannot be used depending on the type of the product to be connected. Further, there is a possibility that Sn remaining after the step of soldering may be melted and flown out in a subsequent step of soldering, and there is a problem that this soldering is low in reliability as a high temperature solder which is used for a bonding method with temperature hierarchy.

That is, for example, when in a manufacturing step of a semiconductor device, a semiconductor device is manufactured after undergoing a step of soldering, and then the semiconductor device is mounted on a substrate by a reflow soldering method, there is a possibility that Sn remaining after the step of soldering in the manufacturing step of a semiconductor device is melted and flown out in a step of reflow soldering.

Further, it is necessary to heat the solder paste at a high-temperature for a long time in the soldering step in order to convert the low melting point metal entirely to the intermetallic compound so that Sn may not remain, but it is a reality that this heating is practically impossible in consideration of balance with productivity.

### PRIOR ART DOCUMENT

### PATENT DOCUMENT

Patent Document 1: Japanese Patent Laid-open Publication No. 2002-254194

### SUMMARY OF THE INVENTION

### Problems to be solved by the invention

The present invention was made in order to solve the above-mentioned problems, and it is an object of the present invention to provide an electroconductive material which can be used as a solder paste or a via filling material, and which has excellent strength in high temperatures, has good diffusion of a first metal and a second metal in a soldering step when the material is used, for example, as a solder paste, produces an intermetallic compound having a high melting point at a low temperature and in a short time, and in which after soldering, a low melting point component hardly remains, and a connection method and connection structure using the material and having high connection reliability.

### Means for solving the problems

In order to solve the problems, the electroconductive material of the present invention is an electroconductive material including a metal component containing a first metal and a second metal having a higher melting point than the first metal, wherein the first metal is Sn or an alloy containing Sn, and the second metal is a Cu-Cr alloy which forms, with the first metal, an intermetallic compound exhibiting a melting point of 310°C or higher.

Further, the electroconductive material of the present invention preferably contains a flux component.

The first metal is preferably Sn alone or an alloy containing Sn and at least one selected from the group consisting of Cu, Ni, Ag, Au, Sb, Zn, Bi, In, Ge, Al, Co, Mn, Fe, Cr, Mg, Mn, Pd, Si, Sr, Te and P.

The connection method of the present invention is characterized in that in a method of connecting connecting objects to each other by using an electroconductive material, the electroconductive material according to any one of claims 1 to 3 is used and heated to convert the first metal constituting the electroconductive material to an intermetallic compound between the first metal and the second metal constituting the electroconductive material to connect connecting objects to each other.

Further, the connection structure of the present invention is a connection structure in which connecting objects are connected to each other by using the electroconductive material according to any one of claims 1 to 3, wherein a connecting part making a connection between connecting objects contains the second metal originating from the electroconductive material and an intermetallic compound containing the second metal and Sn as principal components, and a ratio of the first metal originating from the electroconductive material to the whole metal components is 50% by volume or less.

In the connection structure of the present invention, the intermetallic compound is desirably an intermetallic compound formed between a Cu-Cr alloy which is the second metal originating from the electroconductive material and Sn alone or an alloy containing Sn and at least one selected from the group consisting of Cu, Ni, Ag, Au, Sb, Zn, Bi, In, Ge, Al, Co, Mn, Fe, Cr, Mg, Mn, Pd, Si, Sr, Te, and P, which is the first metal originating from the electroconductive material.

### EFFECTS OF THE INVENTION

Since the electroconductive material of the present invention is an electroconductive material including a metal component containing a first metal and a second metal having a higher melting point than the first metal, and is adapted to contain Sn or an alloy containing Sn as the first metal and a Cu-Cr alloy which forms, with the first metal, an intermetallic compound exhibiting a melting point of 310°C or higher as the second metal, the diffusion of the first metal and the second metal proceeds outstandingly to accelerate the conversion to an intermetallic compound having a higher melting point and the low melting point component becomes hard to remain, and therefore it becomes possible to make connection (e.g., soldering in the case of using the electroconductive material of the present invention as a solder paste) which is high in strength in high temperature.

That is, by using the electroconductive material of the present invention, for example, even when in a manufacturing step of a semiconductor device, a semiconductor device is manufactured after undergoing a soldering step, and then the semiconductor device is mounted on a substrate by a reflow soldering method, a portion soldered in the above-mentioned soldering step has excellent strength in high temperature, and therefore the soldered portion hardly remelts in a step of reflow soldering to enable to perform highly reliable mounting.

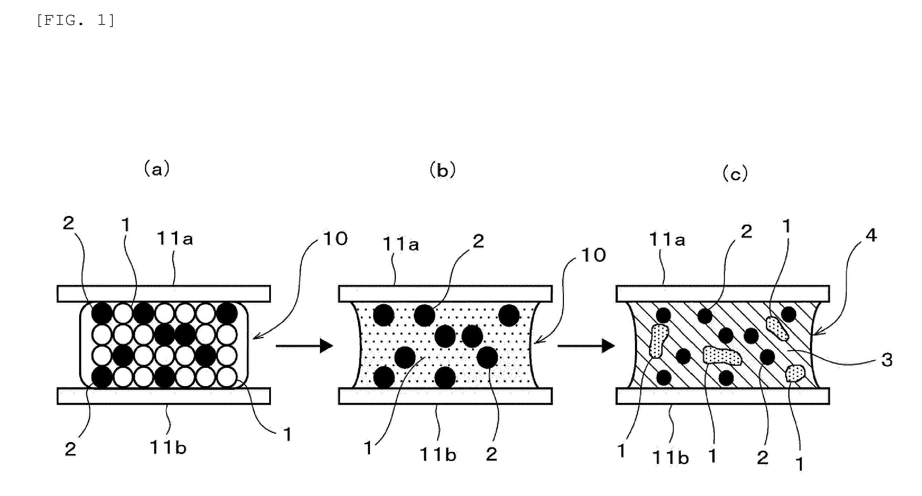

FIG. 1(a), FIG. 1(b), and FIG. 1(c) are views schematically showing the behavior in making a connection between electrodes by using the electroconductive material of the present invention.

First, as shown in FIG. 1(a), an electroconductive material 10 containing a first metal 1 and a second metal 2 is placed between a pair of electrodes 11a and 11b when the pair of electrodes 11a and 11b are connected to each other by using the electroconductive material of the present invention.

Next, a connecting part is heated in this state, and the first metal 1 in the electroconductive material 10 is melted, as shown in FIG. 1(b), when a temperature of the electroconductive material 10 reaches a melting point of the first metal (Sn or alloy containing Sn) 1 or higher.

When thereafter, heating is further continued, the first metal 1 forms an intermetallic compound 3 (FIG. 1(c)) between the first metal 1 and the second metal 2 (Cu-Cr alloy), and the content of the first metal 1 in a connecting part 4 is decreased by the amount of the intermetallic compound 3 formed to increase a melting point of the connecting part 4. Consequently, it becomes possible to perform soldering having high strength in high temperature.

In addition, a mechanism, in which the first metal 1 efficiently forms the intermetallic compound 3 (FIG. 1(c)) with the second metal 2 (Cu-Cr alloy), is not necessarily clear, but it is understood that the intermetallic compound 3 is formed chiefly for the following reason.

That is, it is thought that in the electroconductive material 10 of the present invention, since the second metal 2 is a Cu-Cr alloy, and Cr having smaller first ionization energy than Cu is solid-solved in Cu constituting the Cu-Cr alloy, Cr is oxidized prior to Cu, and consequently diffusion of Cu not oxidized into a melted first metal is promoted, and the second metal forms an intermetallic compound 3 with the first metal 1 (FIGS. 1(a) and 1(b)) in an extremely short time, and the content of the first metal in the connecting part 4 is decreased by the amount of the intermetallic compound 3 formed, and thereby, a melting point of the connecting part 4 is increased to improve the strength in high temperature.

However, in the case of the electroconductive material of the present invention, usually, most of the first metal reacts with the second metal to form an intermetallic compound, but not all of the first metal is converted to the intermetallic compound, and there may be cases where a part of the first metal 1 remains as-is without reacting with the second metal, as shown in FIG. 1(c). However, since the content of the first metal 1 is reduced by the amount of the first metal converted to the intermetallic compound 3 to increase a melting point of the connecting part 4, the strength in high temperature can be improved. Further, when a part of the first metal 1 remains without reacting, self-alignment in soldering can be improved.

In addition, FIG. 1(a) to FIG. 1(c) are schematic views for describing the present invention in an easy-to-understand manner thoroughly, and these drawing do not show exactly a specific constitution of an actual joint portion.

Further, by using, as the first metal, Sn alone or an alloy containing Sn and at least one selected from the group consisting of Cu, Ni, Ag, Au, Sb, Zn, Bi, In, Ge, Al, Co, Mn, Fe, Cr, Mg, Pd, Si, Sr, Te, and P, it becomes possible to facilitate the formation of the intermetallic compound between the first metal and another metal (second metal), and the present invention can be made to be more effective.

The second metal may contain impurities to such an extent that a reaction of the second metal with the first metal is not impaired, for example, at a rate of 1 weight % or less. Examples of the impurities include Zn, Ge, Ti, Sn, Al, Be, Sb, In, Ga, Si, Ag, Mg, La, P, Pr, Th, Zr, B, Pd, Pt, Ni, and Au.

When considering the ability to be connected or reactivity, an oxygen concentration in the first metal and the second metal is preferably 2000 ppm or less, and particularly preferably 10 to 1000 ppm.

The electroconductive material of the present invention can contain a flux.

The flux has the function to eliminate an oxide layer on the surface of the connecting object or the metal. Publicly known various materials including a vehicle, a solvent, a thixotropic agent, an activator and the like can be used as a flux in the electroconductive material of the present invention.

Specific examples of the vehicle include rosin-based resins and synthetic resins consisting of a rosin and derivatives such as a modified rosin obtained by modifying the rosin, and mixtures thereof.

Further, specific examples of the rosin-based resin consisting of the rosin and derivatives such as a modified rosin obtained by modifying the rosin include gum rosins, tall rosins, wood rosins, polymerized rosins, hydrogenated rosins, formylated rosins, rosin esters, rosin modified maleic resins, rosin modified phenol resins, rosin modified alkyd resins and various kinds of other rosin derivatives.

Further, specific examples of the synthetic resins consisting of a rosin and derivatives such as a modified rosin obtained by modifying the rosin include polyester resins, polyamide resins, phenoxy resins and terpene resins.

Further, as the solvent, alcohols, ketones, esters, ethers, aromatic solvents and hydrocarbons are known, and specific examples thereof include benzyl alcohol, ethanol, isopropyl alcohol, butanol, diethylene glycol, ethylene glycol, glycerin, ethyl cellosolve, butyl cellosolve, ethyl acetate, butyl acetate, butyl benzoate, diethyl adipate, dodecane, tetradecene, α-terpineol, terpineol, 2-methyl-2,4-pentanediol, 2-ethylhexanediol, toluene, xylene, propylene glycol monophenyl ether, diethylene glycol monohexyl ether, ethylene glycol monobutyl ether, diethylene glycol monobutyl ether, diisobutyl adipate, hexylene glycol, cyclohexane dimethanol, 2-terpinyloxy ethanol, 2-dihydroterpinyloxy ethanol and mixtures thereof.

Further, specific examples of the thixotropic agent include hardened castor oil, carnauba wax, amides, hydroxy fatty acids, dibenzylidene sorbitol, bis(p-methylbenzylidene)sorbitols, bees wax, amide stearate and ethylenebisamide hydroxystearate. Further, materials obtained by adding a fatty acid such as caprylic acid, lauric acid, myristic acid, palmitic acid, stearic acid or behenic acid, a hydroxy fatty acid such as 1,2-hydroxystearic acid, an antioxidant, a surfactant, amines or the like to the above-mentioned substances as required may also be used as the thixotropic agent.

Examples of the activators include hydrohalide salts of amine, organic halogen compounds, organic acids, organic amines and polyhydric alcohols, and specific examples of the hydrohalide salts of amine include diphenylguanidine hydrobromide, diphenylguanidine hydrochloride, cyclohexylamine hydrobromide, ethylamine hydrochloride, ethylamine hydrobromide, diethylaniline hydrobromide, diethylaniline hydrochloride, triethanolamine hydrobromide, and monoethanolamine hydrobromide.

In addition, specific examples of the organic halogen compounds include paraffin chloride, tetrabromoethane, dibromopropanol, 2,3-dibromo-1,4-butanediol, 2,3-dibromo-2-butene-1,4-diol and tris(2,3-dibromopropyl)isocyanurate.

Specific examples of the organic acid include malonic acid, fumaric acid, glycolic acid, citric acid, malic acid, succinic acid, phenylsuccinic acid, maleic acid, salicylic acid, anthranilic acid, glutaric acid, suberic acid, adipic acid, sebacic acid, stearic acid, abietic acid, benzoic acid, trimellitic acid, pyromellitic acid and dodecanoic acid, and specific examples of the organic amine include monoethanolamine, diethanolamine, triethanolamine, tributylamine, aniline and diethylaniline.

Examples of the polyhydric alcohol include erythritol, pyrogallol and ribitol.

Further, also when using, as the flux, one containing at least one material selected from the thermosetting resin group consisting of an epoxy resin, a phenol resin, a polyimide resin, a silicon resin or a modified silicon resin and an acrylic resin, or at least one material selected from the thermoplastic resin group consisting of a polyamide resin, a polystyrene resin, a polymethacrylic resin, a polycarbonate resin and a cellulose resin, it becomes possible to achieve the operation and effect of the present invention described above with more reliability.

Since as described above, the flux has the function to eliminate an oxide layer on the surface of the connecting object or the metal, the electroconductive material of the present invention preferably contains a flux. In addition, the flux is preferably contained in the proportions of 7 to 15% by weight to the whole electroconductive material.

However, the electroconductive material of the present invention does not necessarily require including a flux, and can be applied to a connection process not requiring a flux, and, for example, a method of heating while pressurizing a connecting object or a method of heating a connecting object in a strongly reducing atmosphere can also eliminate the oxide layer on the surface of the connecting object or the metal to enable highly reliable connection.

Further, since in the connection method of the present invention, it is adapted to convert a low melting point metal constituting the electroconductive material to an intermetallic compound between the low melting point metal and the second metal constituting the electroconductive material by using and heating the electroconductive material of the present invention to connect connecting objects to each other, the diffusion of the first metal and the second metal proceeds outstandingly to accelerate the conversion to an intermetallic compound having a higher melting point in the step of connecting (soldering step in the case of using the electroconductive material as a solder paste) between connecting objects, and therefore it becomes possible to perform soldering having high strength in high temperature by setting a ratio of the first metal component to the whole metal components, for example, to 50% by volume or less.

Moreover, it is possible to design the first metal component to completely avoid remaining by optimizing a mixing ratio of metal in the electroconductive material or heating conditions.

That is, by using the electroconductive material of the present invention, for example, even when in a manufacturing step of a semiconductor device, a semiconductor device is manufactured after undergoing a soldering step, and then the semiconductor device is mounted on a substrate by a reflow soldering method, a portion soldered in the above-mentioned soldering step has excellent strength in high temperature, and therefore the soldered portion does not remelt in a step of reflow soldering to enable to perform highly reliable mounting.

In the connection structure of the present invention, as shown in FIG. 1(c), most of the first metal forms an intermetallic compound 3 between the first metal and a second metal in a connecting part (solder) 4 making a connection between connecting objects (electrodes) 11a and 11b. As a result of this, the connecting part 4 is composed of the second metal 2 and the intermetallic compound 3, and an amount of the remaining first metal 1 (FIGS. 1(a) and 1(b)) is largely reduced, and therefore a connection structure having high strength in high temperature can be realized.

Further, when the intermetallic compound is an intermetallic compound formed between a Cu-Cr alloy which is the second metal originating from the electroconductive material and Sn alone or an alloy containing Sn and at least one selected from the group consisting of Cu, Ni, Ag, Au, Sb, Zn, Bi, In, Ge, Al, Co, Mn, Fe, Cr, Mg, Mn, Pd, Si, Sr, Te, and P, which is the first metal originating from the electroconductive material, it is possible to provide, with more reliability, a connection structure in which almost none of the first metal component remains and strength in high temperatures is high.

### BRIEF EXPLANATION OF DRAWINGS

FIG. 1 is a view schematically showing the behavior in making connection by using an electroconductive material of the present invention, and FIG. 1(a) is a view showing a state before heating, FIG. 1(b) is a view showing a state in which heating is initiated and a first metal is melted, and FIG. 1(c) is a view showing a state in which heating is continued and a main part of the first metal forms an intermetallic compound with a second metal.
FIG. 2 is a view showing a reflow profile in mounting a brass terminal on an oxygen-free Cu plate by using the electroconductive material of the present invention.
FIGS. 3(a) and 3(b) are views schematically showing a constitution of a foamed solder of Variation Example of the electroconductive material of the present invention.
FIG. 4 is a view showing the behavior of a solder in soldering by using a conventional solder paste, and FIG. 4(a) is a view showing a state before heating and FIG. 4(b) is a view showing a state after the completion of a soldering step.

### BEST MODE FOR CARRYING OUT THE INVENTION

Hereinafter, the following Examples will be shown as embodiments of the present invention, and features of the present invention will be described in more detail.

### Example 1

In the present Example 1, an electroconductive material was prepared by mixing a powdery first metal (first metal powder), a powdery second metal (second metal powder) and a flux.

A mixing ratio of the first metal powder and the second metal powder was adjusted so as to be 60/40 in terms of a volume ratio of the first metal powder to the second metal powder (that is, the amount of the second metal is 40% by volume).

As the first metal powder, as shown in Table 1, Sn-3Ag-0.5Cu, Sn, Sn-3.5Ag, Sn-0.75Cu, Sn-0.7Cu-0.05Ni, Sn-5Sb, Sn-2Ag-0.5Cu-2Bi, Sn-3.5Ag-0.5Bi-8In, Sn-9Zn, or Sn-8Zn-3Bi was used. An average particle diameter of the first metal powder was set to 25 µm.

Further, Sn-3Ag-0.5Cu of the first metal was used not only in Example, but also in Comparative Example, but in the case of Comparative Example, metal formed by combining Cu or Cu-10Z with the Sn-3Ag-0.5Cu was used.

In addition, in the above expressions of the respective materials, for example, the numeral 3.5 of "Sn-3.5Ag" indicates a value of weight % of a relevant component (Ag in this case), and the same is true for other materials described above and in the following description.

As the second metal powder, as shown in Table 1, a metal member composed of Cu-10Cr, Cu or Cu-10Zn was used. An average particle diameter of the second metal powder was set to 30 µm.

In addition, as the flux, a mixture composed of rosin, diethylene glycol monobutyl ether, triethanol amine and hydrogenated castor oil in proportions of 74 : 22 : 2 : 2 by weight was used.

Further, a mixing ratio of the flux was adjusted to 10% by weight with respect to the whole electroconductive material.

The prepared electroconductive material was printed on an oxygen-free Cu plate having a size of 10 mm × 10mm and a thickness of 0.2 mm by using a metal mask. The metal mask has an opening diameter of 1.5 mm × 1.5 mm and a thickness of 100 µm.

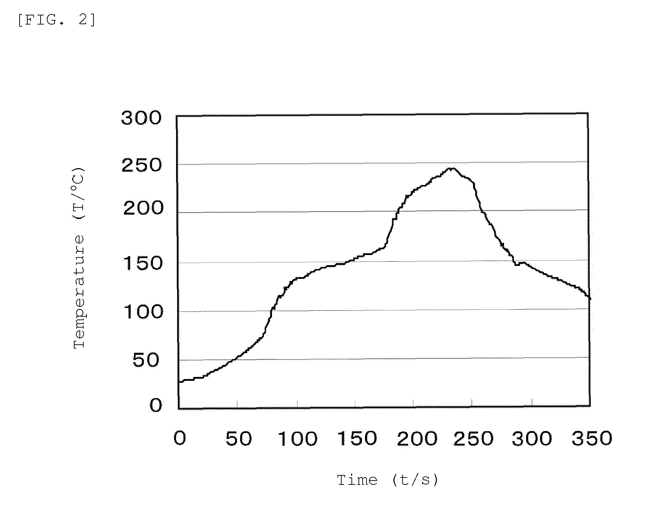

A brass terminal (size 1.2 mm × 1.0 mm × 1.0 mm) given Ni plating and Au plating was mounted on the printed electroconductive material, and then the oxygen-free Cu plate was joined to the brass terminal according to a reflow profile shown in FIG. 2 to electrically and mechanically connect them to each other by using a reflow apparatus.

In addition, in Example 1, the electroconductive material was used substantially as a solder paste.

### [Evaluation of Characteristics]

The joint strengths and the flow out percent defectives of the electroconductive materials (solders) of samples thus prepared were measured by the following methods and these characteristics were evaluated.

### «Joint Strength»

Shear strength of the obtained joined body was measured by using a bonding tester, and evaluated.

Measurement of the shear strength was carried out under conditions of a lateral push rate: 0.1 mm/s⁻¹ and room temperature and 260°C.

The sample having the shear strength of 20 Nmm⁻² or more was rated as "○" (excellent), and the sample having the shear strength of 2 Nmm⁻² or less was rated as "×"

### (defective).

Composition of the first metal and the second metal, and the joint strength (room temperature, 260°C) of the respective joined bodies are shown in Table 1.

### «Evaluation of Remaining Component»

A portion of about 7 mg of the obtained reaction product was cut off, and subjected to differential scanning calorimetry (DSC) using Al₂O₃ as a reference under conditions of a measurement temperature of 30°C to 300°C and a temperature raising rate of 5°C/min in a nitrogen atmosphere. An amount of a remaining first metal component was quantified from an endothermic quantity of an endothermic melting peak at a melting temperature of the first metal component in the resulting DSC chart. A ratio of the first metal component to the whole metal components was evaluated as a ratio of a remaining first metal component from the quantified amount. The case where the ratio of a remaining first metal component was 50% by volume or less was rated as "O" (excellent), and the case where the ratio was more than 50% by volume was rated as "×" (defective).

The ratios of a remaining first metal component and rating results are shown together in Table 1.

### «Measurement and Evaluation of Flow Out Percent Defective of Electroconductive Material»

The electroconductive material was applied (thickness 100 µm) onto a Cu land (Cu land dimension: 0.7 mm × 0.4 mm) of a printed board, and on the resulting applied area, a ceramic capacitor of a chip type having a size of 1 mm long, 0.5 mm wide and 0.5 mm thick was mounted.

After the ceramic capacitor mounted on the printed board was reflowed at a peak temperature of 250°C to join (solder) the ceramic capacitor to the Cu land, the printed board was sealed with an epoxy resin, left standing in an environment of 85% in relative humidity, and heated in the reflow condition of a peak temperature of 260°C to determine a percentage of the electroconductive material (solder) which was flown out. This percentage was taken as a flow out percent defective and the flow out percent defective was evaluated.

The case where the flow out percent defective of the electroconductive material was 0 to 50% was rated as "O" (excellent), and the case where the flow out percent defective was more than 50% was rated as "×" (defective).

The flow out percent defective and the results of evaluation of the electroconductive material are shown together in Table 1.

**[Table 1]**

| | First Metal Component | Second Metal Component | Joint Strength and Evaluation (Room Temperature) | | Joint Strength and Evaluation (260°C) | | Evaluation of Remaining Component | | Evaluation of Flow Out | |
|---|---|---|---|---|---|---|---|---|---|---|
| | | Composition | Joint Strength (Nmm^{- 2}) | Rating | Joint Strength (Nmm^{- 2}) | Rating | Ratio of Remainin g First Metal Componen t (% by volume) | Rating | Joint Strength (Nmm^{- 2}) | Rating |
| Example | Sn-3Ag-0.5Cu | Cu-10Cr | 24 | ○ | 23 | ○ | 47 | ○ | 35 | ○ |
| | Sn | Cu-10Cr | 26 | ○ | 26 | ○ | 45 | ○ | 34 | ○ |
| | Sn-3.5Ag | Cu-10Cr | 27 | ○ | 25 | ○ | 45 | ○ | 33 | ○ |
| | Sn-0.75Cu | Cu-10Cr | 27 | ○ | 25 | ○ | 46 | ○ | 34 | ○ |
| | Sn-0.7Cu-0.05Ni | Cu-10Cr | 26 | ○ | 25 | ○ | 45 | ○ | 33 | ○ |
| | Sn-5Sb | Cu-10Cr | 29 | ○ | 28 | ○ | 49 | ○ | 36 | ○ |
| | Sn-2Ag-0.5Cu-2Bi | Cu-10Cr | 27 | ○ | 27 | ○ | 48 | ○ | 35 | ○ |
| | Sn-3.5Ag-0.5Bi-8In | Cu-10Cr | 28 | ○ | 27 | ○ | 45 | ○ | 35 | ○ |
| | Sn-9Zn | Cu-10Cr | 29 | ○ | 26 | ○ | 46 | ○ | 35 | ○ |
| | Sn-8Zn-3Bi | Cu-10Cr | 27 | ○ | 26 | ○ | 46 | ○ | 34 | ○ |
| Comparative Example | Sn-3Ag-0.5Cu | Cu | 24 | ○ | 0.1 | × | 74 | × | 88 | × |
| | | Cu-10Zn | 31 | ○ | 1.9 | × | 71 | × | 75 | × |

As shown in Table 1, with respect to the joint strength at room temperature, each of samples of both Examples and Comparative Examples exhibited joint strength of 20 Nmm⁻² or more, and was found to have practical strength.

On the other hand, with respect to the joint strength at 260°C, while the samples of Comparative Examples exhibited insufficient joint strength of 2 Nmm⁻² or less, the samples of Examples held the joint strength of 20 Nmm⁻² or more, and were found to have practical strength.

With respect to the ratio of a remaining first metal component, while the samples of Comparative Examples had a ratio of a remaining first metal component more than 50% by volume, all of the samples of Examples had a remaining first metal component of 50% by volume or less. With respect to the flow out percent defective of the electroconductive material, while the samples of Comparative Examples had a flow out percent defective of 70% or more, all of the samples of Examples had a flow out percent defective of 50% or less, and were found to have high heat resistance.

The reason why the samples of Examples have high heat resistance as described above is likely that in the case of Examples in which the Cu-Cr alloys are used as the second metal, first ionization energy of Cr solid-solved is as small as 653 kJ-mol⁻¹ relative to Cu having first ionization energy of 746 kJ-mol⁻¹.

That is, since Cr having small first ionization energy is solid-solved in Cu, ionization of Cr or oxidation of Cr suppresses oxidation of Cu which is diffusion-driven to promote a reaction (formation of an intermetallic compound) between the first metal and Cu.

On the other hand, in the case of using the Cu-Zn alloy as the second metal like Comparative Example, it is thought that since first ionization energy of Zn is 906 kJ-mol⁻¹ larger than that of Cu, the oxidation of Cu which is diffusion-driven becomes marked, and formation of an intermetallic compound does not efficiently proceed, and therefore high heat resistance is not attained.

### [Variation Example]

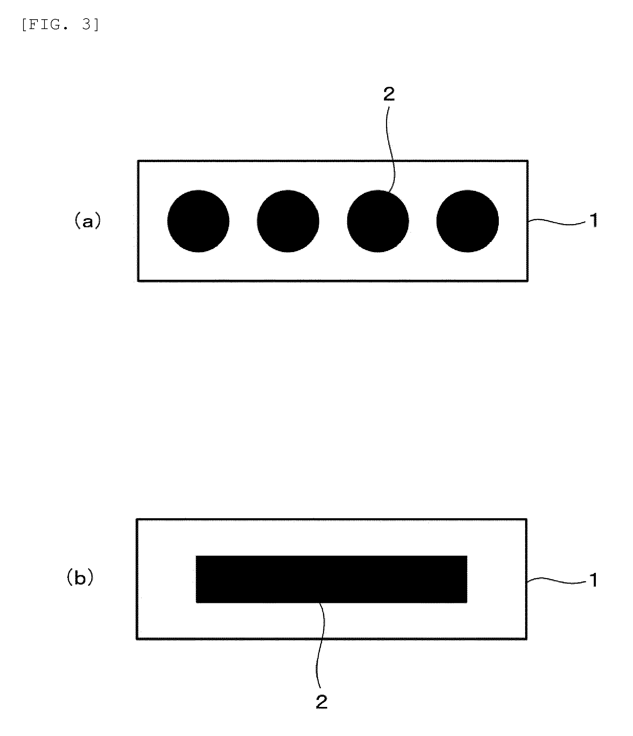

The electroconductive material of the present invention can also be constituted, for example, as a foamed solder as schematically shown in FIGS. 3(a) and 3(b).

The foamed solder in FIG. 3(a) is a foamed solder formed by dispersing a powdery second metal 2 in a plate-shaped first metal 1.

Further, the foamed solder in FIG. 3(b) is a foamed solder formed by including a plate-shaped second metal 2 in a plate-shaped first metal 1.

Also when the electroconductive material of the present invention is used as the foamed solder as shown in FIGS. 3(a) and 3(b), the electroconductive material achieves the same effect as in the case where the electroconductive material is used as the so-called solder paste formed by mixing the first metal, the second metal and the flux, which has been described in Example 1.

In addition, the embodiment of dispersing or including the second metal in the first metal is not limited to embodiments of FIGS. 3(a) and 3(b), and other embodiments may be employed.

The present invention is not intended to be limited to the above-mentioned examples, and various applications and variations may be made on types and composition of the first metal and the second metal, respectively constituting the electroconductive material, a mixing ratio of the first metal and the second metal, or components of the flux or a mixing ratio of a flux within the scope of the invention.

Also, various applications and variations may be made on types of connecting objects to be connected to each other by applying the present invention or conditions in a connecting step within the scope of the invention.

In the present invention, further various applications and variations may also be made in other respects within the scope of the invention.

### DESCRIPTION OF REFERENCE SYMBOLS

- 1: first metal
- 2: second metal
- 3: intermetallic compound
- 4: connecting part
- 11a, 11b: a pair of electrodes (connecting object)
- 10: electroconductive material

## Claims

1. An electroconductive material including a metal component containing a first metal and a second metal having a higher melting point than the first metal,
wherein the first metal is Sn or an alloy containing Sn, and
the second metal is a Cu-Cr alloy which forms, with the first metal, an intermetallic compound exhibiting a melting point of 310°C or higher.

2. The electroconductive material according to claim 1, wherein the electroconductive material contains a flux component.

3. The electroconductive material according to one of claims 1 and 2,
wherein the first metal is Sn alone or an alloy containing Sn and at least one selected from the group consisting of Cu, Ni, Ag, Au, Sb, Zn, Bi, In, Ge, Al, Co, Mn, Fe, Cr, Mg, Pd, Si, Sr, Te and P.

4. A connection method of connecting connecting objects to each other by using an electroconductive material, wherein the electroconductive material according to any one of claims 1 to 3 is used and heated to convert the first metal and the second metal, which respectively constitute the electroconductive material, to an intermetallic compound to connect connecting objects to each other.

5. A connection structure in which connecting objects are connected to each other by using the electroconductive material according to any one of claims 1 to 3,
wherein an electroconductive material of a connecting part making a connection between connecting objects contains the second metal originating from the electroconductive material and an intermetallic compound containing the second metal and Sn as principal components, and a ratio of the first metal originating from the electroconductive material to the whole metal components is 50% by volume or less.

6. The connection structure according to claim 5, wherein the intermetallic compound is an intermetallic compound formed between a Cu-Cr alloy which is the second metal originating from the electroconductive material and Sn alone or an alloy containing Sn and at least one selected from the group consisting of Cu, Ni, Ag, Au, Sb, Zn, Bi, In, Ge, Al, Co, Mn, Fe, Cr, Mg, Pd, Si, Sr, Te, and P, which is the first metal originating from the electroconductive material.
